# EUROPEAN PATENT SPECIFICATION

(11) **EP 4 098 783 B1**
(45) Date of publication and mention of the grant of the patent: **03.04.2024**
(21) Application number: 22755526.5
(22) Date of filing: 10.02.2022
(51) Int. Cl.: C30B 25/18, C30B 25/20, C30B 29/36, H01L 21/02

(54) **BUFFER LAYER ON SILICON CARBIDE SUBSTRATE, AND METHOD FOR FORMING BUFFER LAYER**
PUFFERSCHICHT AUF SILIZIUMKARBIDSUBSTRAT UND VERFAHREN ZUR HERSTELLUNG EINER PUFFERSCHICHT
COUCHE TAMPON SUR UN SUBSTRAT DE CARBURE DE SILICIUM ET PROCÉDÉ DE FORMATION D'UNE COUCHE TAMPON

(30) Priority: 18.02.2021 CN 202110186694
(43) Date of publication of application: 07.12.2022
(73) Proprietor: UNT POWER (SHAOXING) CO., LTD., Zhejiang 312000 (CN)
(72) Inventor: LI, Xiang, Shaoxing, Zhejiang 312000 (CN); CONG, Maojie, Shaoxing, Zhejiang 312000 (CN); XIE, Zhiping, Shaoxing, Zhejiang 312000 (CN); KAN, Zhiguo, Shaoxing, Zhejiang 312000 (CN); LIU, Xuanjie, Shaoxing, Zhejiang 312000 (CN)
(74) Representative: Kraus & Lederer PartGmbB
(86) International application number: PCT/CN2022/075930
(87) International publication number: WO 2022/174753

(56) References cited:
- CN-A- 1 628 370
- CN-A- 106 711 031
- CN-A- 107 068 539
- CN-A- 112 522 781
- DE-T5-112011 102 787
- JP-A- 2008 074 661
- JP-A- 2012 074 513
- JP-A- 2013 018 659
- US-A1- 2002 158 251
- US-A1- 2002 158 251
- US-A1- 2007 032 053
- US-A1- 2012 241 766

## Description

### TECHNICAL FIELD

The present invention relates to the field of semiconductor technology and, in particular, to a buffer layer on a silicon carbide substrate and a method of formation thereof, as well as to a silicon carbide epitaxial wafer and a method of forming the same.

### BACKGROUND

Silicon carbide (SiC), a wide bandgap semiconductor material, exhibits high thermal conductivity, high breakdown electric field, high saturated electron drift velocity, high bonding energy and other outstanding advantages. Its excellent performance can satisfy the high temperature, high frequency, high power, radiation resistance and other requirements of modem electronics.

However, the quality and surface conditions of silicon carbide substrates do not meet the requirements for direct fabrication of devices. For example, there are generally many dislocation defects (including threading screw dislocations, threading edge dislocations, basal stacking faults, etc.) in silicon carbide substrates. For this reason, it is typically necessary to epitaxially grow a silicon carbide epitaxial layer over the surface of a silicon carbide substrate. This epitaxial layer has higher quality and better electrical properties, controllability and reproducibility than the silicon carbide substrate.

However, during epitaxial growth, some dislocations in the silicon carbide substrate may spread into the silicon carbide epitaxial layer being grown, leading to a certain number of defects in the resulting silicon carbide epitaxial layer.

Layer forming methods according to the prior art are known from documents US 2002/158251 A1 and DE 11 2011 102787 T5.

### SUMMARY

It is an object of the present invention to provide a buffer layer on a silicon carbide substrate and a method of forming the same, which solve the problem of dislocations tending to externally spread from a silicon carbide substrate into an overlying layer. This is achieved by the invention, which is defined by the independent claims.

To this end, the present invention provides a method of forming a buffer layer on a silicon carbide substrate, including: in a first step, forming a silicon carbide film on a surface of the silicon carbide substrate; in a second step, treating the surface of the silicon carbide film with predetermined ions so that a top doped region of the silicon carbide film around the top surface is doped with the predetermined ions, has an increased concentration of the predetermined ions and has a thickness that is less than 10 nm and is less than a thickness of the remaining portion of same silicon carbide film under the top doped region; in a third step, forming another silicon carbide film on the silicon carbide film; and repeating the second and third steps at least once to successively form at least two layers of silicon carbide films which make up the buffer layer.

Moreover, the silicon carbide substrate may be successively subject to the first to third steps within the same process chamber.

Additionally, the first step may include forming the silicon carbide film by introducing a carbon-source gas and a silicon-source gas to the process chamber, wherein the second step includes stopping the introduction of the carbon-source gas and the silicon-source gas and then doping the top surface of the silicon carbide film by introducing a source of the predetermined ions to the process chamber, and wherein the third step includes stopping the introduction of the source of the predetermined ions and then growing the other silicon carbide film by again introducing the silicon-source gas and the carbon-source gas.

Optionally, the predetermined ions may be n-type dopant ions or p-type dopant ions. Additionally, the n-type dopant ions may be nitrogen ions or phosphorus ions, and the p-type dopant ions may be aluminum ions or boron ions.

Optionally, the silicon carbide film may have a thickness of from 10 nm to 200 nm. Additionally, the buffer layer may have a thickness of from 200 nm to 1000 nm.

Optionally, the second and third steps may be repeated at least twice or more times to form a plurality of layers of silicon carbide films.

The present invention also provides a method of forming a silicon carbide epitaxial wafer, including: providing a silicon carbide substrate; successively forming at least two layers of silicon carbide films on the silicon carbide substrate using the method as defined above, which make up a buffer layer; and forming an epitaxial layer on the buffer layer.

The present invention also provides a buffer layer on a silicon carbide substrate formed using the method as defined above. The buffer layer includes at least two adjacent layers of silicon carbide films formed on the silicon carbide substrate, in adjacent layers of silicon carbide films, at least a top doped region of a lower one of the silicon carbide film close to a top surface of the silicon carbide film is doped with predetermined ions, so as to increase concentration of the predetermined ions in the top doped region . The top doped region has a thickness that is less than 10 nm and is less than a thickness of the remaining portion of the same silicon carbide film under the top doped region.

The present invention also provides a silicon carbide epitaxial wafer including the buffer layer as defined above on a silicon carbide substrate.

In the buffer layer on a silicon carbide substrate and the method of formation thereof provided in the present invention, at least two layers of silicon carbide films are formed, in adjacent layers of silicon carbide films, at least a top doped region of a lower one of the silicon carbide film close to a top surface of the silicon carbide film is doped with predetermined ions. As a result, parameters of this top doped region of the silicon carbide film are modified relative to those of the remaining portion of the film under the top doped region. This is equivalent to the formation of a top doped region with different parameters at the top surface of the silicon carbide film. This top doped region acts as a barrier for the underlying portion, which can effectively block threading dislocation defects from further upward propagation. Upward propagation of dislocations is blocked in a manner that the barrier resulting from the doping with the predetermined ions diverts vertical propagation paths for threading dislocation defects that have spread to the top surface of the silicon carbide film into horizontal paths. This confines the propagation paths for the threading dislocations within the top doped layer, making threading dislocation defects unable to further spread upward.

### BRIEF DESCRIPTION OF THE DRAWINGS

Fig. 1 is a schematic diagram showing the structure of a buffer layer on a silicon carbide substrate according to an embodiment of the present invention.
Fig. 2 is a schematic flow diagram of a method of forming a buffer layer on a silicon carbide substrate according to an embodiment of the present invention.
Figs. 3 to 5 are schematic diagrams showing structures formed in a method of forming a buffer layer according to an embodiment of the present invention.

In these figures, 100-silicon carbide substrate; 200-buffer layer; 210-silicon carbide film; 210a-top doped region; 300-silicon carbide epitaxial layer.

### DETAILED DESCRIPTION

As described in the Background section, when epitaxially growing a silicon carbide epitaxial layer directly on a silicon carbide substrate, dislocation defects in the silicon carbide substrate tend to spread into the silicon carbide epitaxial layer. In order to overcome this, a buffer layer may be disposed between the silicon carbide substrate and the silicon carbide epitaxial layer to prevent dislocation defects in the silicon carbide substrate from spreading into the silicon carbide epitaxial layer, resulting in higher quality of the resulting silicon carbide epitaxial layer. Specifically, the buffer layer may consist of an evenly and heavily doped silicon carbide layer. Although such a heavily doped buffer layer can block the propagation of dislocation defects to a certain extent, its ability to prevent that of threading dislocations is limited. Consequently, there will be still many threading dislocations in the resulting silicon carbide epitaxial layer.

To overcome this, the present invention provides a method of forming a buffer layer. The formed buffer layer includes at least two adjacent silicon carbide films formed over the silicon carbide substrate, in adjacent layers of silicon carbide films, at least a top doped region of a lower one of the silicon carbide film close to a top surface of the silicon carbide film is doped with predetermined ions. That is, the top surface of the silicon carbide film is doped with the predetermined ions to form the top doped region. The top doped region resulting from the doping has thin film parameters that are different from thin film parameters of the remaining portion thereunder and can function as a barrier that blocks further upward propagation of threading dislocation defects in the silicon carbide film.

Buffer layers on silicon carbide substrates and methods of formation thereof according to particular embodiments of the present invention will be described in greater detail below with reference to the accompanying drawings. Advantages and features of the present invention will become more apparent from the following description. Note that the figures are provided in a very simplified form not necessarily drawn to exact scale and for the only purpose of helping to explain the disclosed embodiments in a more convenient and clearer way.

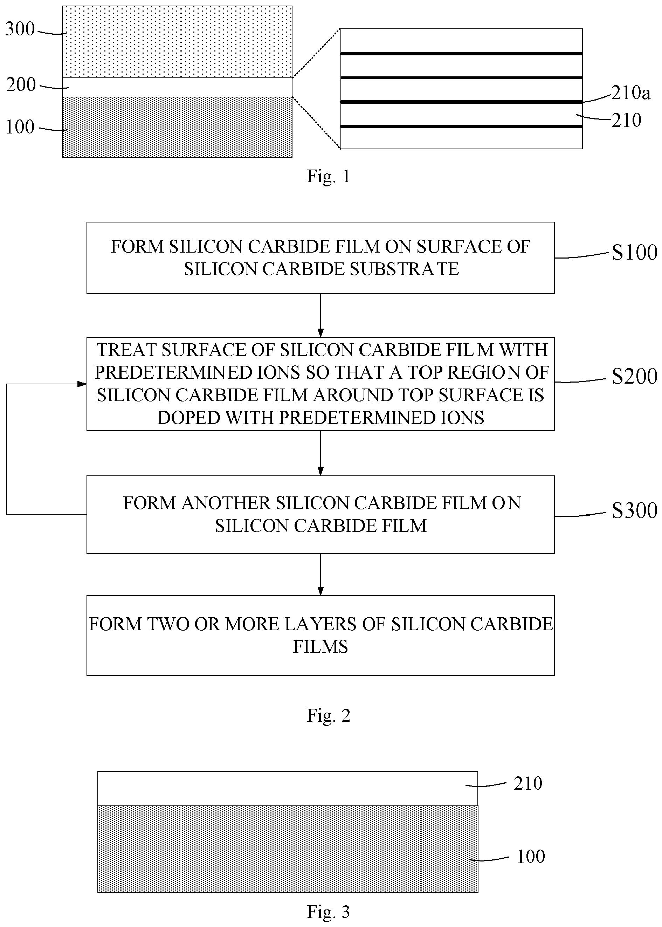

Fig. 1 is a schematic diagram showing the structure of a buffer layer on a silicon carbide substrate according to an embodiment of the present invention. As shown in Fig. 1, the buffer layer 200 includes at least two adjacent layers of silicon carbide films 210 formed on the silicon carbide substrate 100, in the adjacent layers of silicon carbide films 210, at least a top doped region of a lower one of the silicon carbide film close to a top surface of the silicon carbide film is doped with predetermined ions. That is, in the adjacent layers of silicon carbide films 210, a top portion of at least each lower one is doped with the predetermined ions and thus converted into a top doped region 210a with an increased concentration of the predetermined ions. Moreover, for each silicon carbide film 210, a thickness of the top doped region 210a is less than a thickness of the remaining portion thereunder.

According to this embodiment, through doping the top surface of the silicon carbide film 210 with the predetermined ions, parameters of a top portion of the silicon carbide film 210 (i.e., the top doped region 210a) are modified. As a result, propagation paths in the silicon carbide film 210 for threading dislocation defects that have spread from the silicon carbide substrate 100 into the silicon carbide film 210 can be blocked at the top doped region 210a. For example, growth paths in the silicon carbide film 210 for threading dislocation defects that have spread from the silicon carbide substrate 100 into the silicon carbide film 210 are substantially vertical, and the presence of the top doped region 210a around the top surface can horizontally divert the vertical growth paths for the threading dislocation defects, thereby blocking further upward propagation of the threading dislocation defects.

It is to be noted that, in this embodiment, the top doped region 210a is formed by doping the top surface of the silicon carbide film 210, so that the top doped region 210a has a relatively small thickness. It will be recognized that an evenly doped silicon carbide layer formed directly by the combined use of a deposition process and in-situ doping usually has a thickness that cannot be reduced below 10 nm. However, in this embodiment, as the top doped portion is formed by doping with the predetermined ions after the silicon carbide film 210 is formed, it is possible to control the predetermined ions to be doped in the silicon carbide film 210 within a range from the top surface to a depth of less than 10 nm under the top surface. Therefore, the thickness of the resulting top doped region 210a can be controlled within 10 nm, e.g., 5 nm (in this case, the predetermined ions are doped in a range from the top surface to a depth of 5 nm under the top surface), or even 3 nm or less.

It is to be also noted that "doping the predetermined ions within a range from the top surface to a depth of less than 10 nm under the top surface" can be understood as doping the predetermined ions within the topmost two or more atomic layers of the silicon carbide film 210, i.e., doping the top surface of the silicon carbide film 210 with the predetermined ions in a substantially two-dimensional manner, which enables the top doped region 210a to have a thin thickness.

The inventors of the present invention have found from research that a single evenly doped silicon carbide layer with a relatively large thickness cannot block threading dislocations well. By contrast, according to this embodiment, the relatively thin top doped region 210a can effectively block threading dislocations, and at a given total thickness of the buffer layer 200, multiple such top doped regions 210a can be included to even better block threading dislocations.

The number of silicon carbide films 210 in the buffer layer 200 may be determined according to actual circumstances. For example, three to six layers of silicon carbide films 210 may be included, and top surfaces of all the other lower silicon carbide films than and under the topmost silicon carbide film 210 may be doped with the predetermined ions. Of course, a top surface of the topmost silicon carbide film 210 may also be doped with the predetermined ions. It will be recognized that the number of silicon carbide films 210 in the buffer layer 200 may be determined so as to enable blocking of all or many threading dislocation defects, and the present invention is not limited in this regard.

Additionally, the thickness of the buffer layer 200 is, for example, in the range of from 200 nm to 1000 nm, and five layers of silicon carbide films 210 may be included in the buffer layer 200. Thicknesses of the silicon carbide films 210 may be equal or not. In this embodiment, for example, the thicknesses of the silicon carbide films 210 may range from 10 nm to 200 nm. In a particular embodiment, when the thicknesses of the silicon carbide films 210 are 10 nm, for example, the thickness of the top doped region 210a may be about 3 nm, or even less than 3 nm.

The type of the predetermined ions may be determined according to actual circumstances. For example, when the silicon carbide film 210 is non-doped silicon carbide, the predetermined ions with which the top portion of the silicon carbide film 210 is doped may be n-type dopant ions or p-type dopant ions. Alternatively, when the silicon carbide film 210 is n-type lightly doped silicon carbide, the predetermined ions of which the top portion of the silicon carbide film 210 is doped may be n-type dopant ions. Still alternatively, when the silicon carbide film 210 is p-type lightly doped silicon carbide, the predetermined ions of which the top portion of the silicon carbide film 210 is doped may be p-type dopant ions. The n-type dopant ions include, but are not limited to, nitrogen ions, phosphorus ions, etc. The p-type dopant ions include, but are not limited to, aluminum ions, boron ions, etc.

As discussed above, before the silicon carbide film 210 is doped with the predetermined ions, the silicon carbide film 210 may be non-doped silicon carbide. In this case, after being doped with the predetermined ions, the remaining portion of the silicon carbide film 210 under the top doped region 210a will be non-doped silicon carbide. Alternatively, the portion of the silicon carbide film 210 under the top doped region 210a may be lightly doped with the predetermined ions. In this case, the top portion of the silicon carbide film 210 may be doped twice with the predetermined ions to form the top doped region 210a. Additionally, the number of predetermined ions per unit thickness in the top doped region 210a will be greater than in the remaining underlying portion.

In particular, the remaining portion of the silicon carbide film 210 underlying the top doped region 210a may be a non-doped monocrystalline silicon carbide layer (i.e., it is doped neither with the predetermined ions nor with other ions). Alternatively, the portion of the silicon carbide film 210 underlying the top doped region 210a may not be doped with the predetermined ions but with other ions such as, for example, other n-type dopant ions or p-type dopant ions. In this case, the portion of the silicon carbide film 210 underlying the top doped region 210a is either an n-doped silicon carbide layer or a p-doped silicon carbide layer.

Methods of forming the above-described buffer layers on silicon carbide substrates will be described in detail below with reference to Fig. 2 and Figs. 3 to 5. Fig. 2 is a schematic flow diagram of a method of forming a buffer layer on a silicon carbide substrate according to an embodiment of the present invention. Figs. 3 to 5 are schematic diagrams showing structures formed in a method of forming a buffer layer according to an embodiment of the present invention.

First of all, step S 100 is performed, with particular reference to Fig. 3, in which a silicon carbide film 210 is formed on a surface of a silicon carbide substrate 100.

The silicon carbide substrate 100 may be in particular a monocrystalline silicon carbide substrate. Alternatively, the silicon carbide substrate 100 may be a heavily doped n-type silicon carbide substrate or a heavily doped p-type silicon carbide substrate.

The silicon carbide film 210 may be formed in particular by a chemical vapor deposition (CVD) process. In particular, the formation of the silicon carbide film 210 may include: placing the silicon carbide substrate 100 in a process chamber (e.g., a CVD process chamber); and forming the silicon carbide film 210 by introducing a carbon-source gas and a silicon-source gas into the process chamber. In this process, a pressure in the process chamber is maintained, for example, in the range of 20 mbar to 150 mbar, and a temperature in the process chamber is maintained, for example, in the range of 1400 °C to 1700 °C.

Additionally, the carbon-source gas may include, for example, at least one of methane, ethylene, acetylene and propane. The silicon-source gas may include, for example, at least one of dichlorosilane, trichlorosilane and tetrachlorosilane. The carbon-source gas is introduced, for example, at a flow rate of 10 sccm to 200 sccm. The silicon-source gas is introduced, for example, at a flow rate of 10 sccm to 100 sccm.

In particular embodiments, during the introduction of the carbon-source gas and the silicon-source gas, a hydrogen-source gas may be introduced to modify silicon carbide that has been grown to improve quality of the resulting silicon carbide film 210. Wherein, the hydrogen-source gas may include hydrogen and/or hydrogen chloride. Hydrogen may be introduced, for example, at a flow rate of 10 sccm to 200 sccm. In this embodiment, the silicon carbide film 210 may be grown as a monocrystalline silicon carbide layer. Further, the single silicon carbide film 210 formed in the CVD process may have a thickness controlled within the range of 10 nm to 200 nm.

As noted above, the silicon carbide film 210 may be an n-type lightly doped silicon carbide film or a p-type lightly doped silicon carbide film. In the former case, during the CVD process, in addition to the silicon-source gas and the carbon-source gas, a source of n-type ions (e.g., nitrogen, phosphorus trihydride or the like) may also be introduced. In this way, the n-type ions can be evenly doped in the resulting silicon carbide film 210. Likewise, when the grown silicon carbide film 210 is a p-doped silicon carbide film, during the CVD process, in addition to the silicon-source gas and the carbon-source gas, a source of p-type ions (e.g., trimethyl aluminum, boron trifluoride or the like) may also be introduced. In this way, the p-type ions can be evenly doped in the resulting silicon carbide film 210.

Of course, the silicon carbide film 210 may also be a non-doped silicon carbide layer, depending on the actual circumstances.

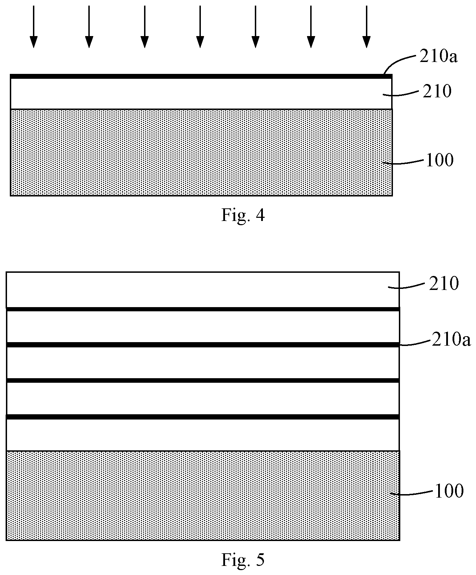

Next, step S200 is performed, with particular reference to Fig. 4, in which a surface of the silicon carbide film 210 is treated with predetermined ions so that a portion of the silicon carbide film 210 around the top surface is doped with the predetermined ions. As a result, the portion of the silicon carbide film 210 around the top surface is converted into a top doped region 210a with an increased concentration of the predetermined ions. A thickness of the top doped region 210a is less than 10 nm and is also less than a thickness of the remaining portion under the top doped region.

In addition, the surface treatment of the silicon carbide film 210 may be accomplished in the same process chamber where the growth of the silicon carbide film 210 is accomplished. That is, after a desired thickness of the silicon carbide film 210 has been reached on the silicon carbide substrate 100 that is placed in the process chamber, the introduction of the carbon-source gas and the silicon-source gas is stopped to prevent further growth of silicon carbide. A source of the predetermined ions is then introduced to the process chamber so that the predetermined ions act on the top surface of the silicon carbide film 210, achieving the top surface doping of the silicon carbide film 210. In practical use, a flow rate of the source of the predetermined ions and/or a surface treatment duration may be properly determined according to a required thickness of the top doped region 210a.

The doping process according to the present embodiment can not only avoid damage to the silicon carbide film 210 but also achieve two-dimensional doping of the top surface of the silicon carbide film 210. As a result, the predetermined ions can be controlled so as to be doped within a range in the silicon carbide film 210 from the top surface to a depth of less than 10 nm under the top surface. This allows the silicon carbide film 210 to have a reduced thickness.

In particular, the predetermined ions may be n-type dopant ions (in this case, a source of n-type ions is introduced) or p-type dopant ions (in this case, a source of p-type ions is introduced). More particularly, when the silicon carbide film 210 is an n-type lightly doped silicon carbide film, the predetermined ions are n-type ions. When the silicon carbide film 210 is a p-type lightly doped silicon carbide film, the predetermined ions are p-type ions.

In this embodiment, the predetermined ions are, for example, nitrogen ions. Accordingly, the source of the predetermined ions may be nitrogen. In this case, during the nitrogen-based surface treatment, nitrogen may be introduced at a flow rate of, for example, from 20 sccm to 2000 sccm, and the nitrogen-based surface treatment may last for 2 to 200 seconds. In practical use, the flow rate of nitrogen and the surface treatment duration may be determined according to a required thickness of the top doped region 210a.

Next, step S300 is performed, to form another silicon carbide film 210 over the aforementioned silicon carbide film. Particular reference may be made to Fig. 5. After step S200 is completed, the introduction of the source of the predetermined ions (e.g., nitrogen) may be stopped, and the silicon-source gas and the carbon-source gas may be again introduced to grow the other silicon carbide film 210.

After steps S200 and S300 are completed, two layers of silicon carbide films 210 are successively formed over the silicon carbide substrate 100, and the top surface of the lower silicon carbide film is two-dimensionally doped with the predetermined ions.

In particular embodiments, steps S200 and S300 may be repeated twice or more times to form two or more layers of silicon carbide films 210, with a total thickness of these layers of silicon carbide films 210 being controlled within the range of 200 nm to 1000 nm. An embodiment with five layers of silicon carbide films 210 being formed as shown in Fig. 5 will be described below as an example.

Further, in this embodiment, in the multiple layers of silicon carbide films 210, all the other silicon carbide films 210 than the topmost one are subject to a top surface treatment for two-dimensional doping of the predetermined ions. However, it will be recognized that, in alternative embodiments, the topmost silicon carbide film 210 may also be subject to such a surface treatment with the predetermined ions.

With continued reference to Fig. 1, a silicon carbide epitaxial layer 300 may be formed on the above-described buffer layer to prepare a silicon carbide epitaxial wafer with improved quality.

Specifically, the buffer layer 200 can provide a blocking effect on threading dislocation defects in the silicon carbide substrate 100. Even when such threading dislocation defects in the silicon carbide substrate 100 have spread into the buffer layer 200, barriers formed by the top surface portions of the silicon carbide film 210 that are doped with the predetermined ions can block additional upward propagation of the threading dislocation defects that have spread into one or more of the silicon carbide films into the overlying silicon carbide epitaxial layer 300 formed on the buffer layer 200, thus ensuring quality of the silicon carbide epitaxial layer 300.

Furthermore, the silicon carbide epitaxial layer 300 may be a lightly doped n-type silicon carbide epitaxial layer, or a lightly doped p-type silicon carbide epitaxial layer.

Here, the term "lightly doped" means that an ion concentration of the silicon carbide epitaxial layer 300 is lower than an ion concentration of the silicon carbide substrate 100. The silicon carbide epitaxial layer 300 has a thickness of, for example, in the range of from 5 µm to 1000 µm.

It is to be understood that while the invention has been described above with reference to preferred embodiments thereof, it is not limited to these embodiments. In light of the above teachings, any person familiar with the art may make many possible modifications and variations to the disclosed embodiments or adapt them into equivalent embodiments, without departing from the scope of the invention, which is defined by the appended claims.

The relative terms "above", "under", "top", "bottom", "front", "rear" and the like as used herein in connection with the orientation depicted in the accompanying drawings can be used to describe relationships between different components. These relative terms are intended to encompass different orientations in addition to the orientation depicted in the figures. For example, if the device in the figures is inverted, an element described as "above" another element would then be oriented "under" the other element.

## Claims

1. A method of forming a buffer layer (200) on a silicon carbide substrate (100), comprising:
in a first step, forming a silicon carbide film (210) on a surface of the silicon carbide substrate (100);
in a second step, treating the surface of the silicon carbide film (210) with predetermined ions so that a top doped region (210a) of the silicon carbide film (210) close to a top surface of the silicon carbide film is doped with the predetermined ions, so as to increase concentration of the predetermined ions in the top doped region (210a), the top doped region (210a) has a thickness of less than 10 nm, and the thickness of the top doped region (210a) is less than a thickness of the remaining portion of same silicon carbide film (210) under the top doped region (210a);
in a third step, forming another layer of silicon carbide film on the silicon carbide film (210); and
repeating the second and third steps at least once to successively form at least two layers of silicon carbide films (210) which make up the buffer layer (200),
wherein the silicon carbide substrate (100) is successively subject to the first to third steps within the same process chamber, wherein the first step comprises forming the silicon carbide film (210) by introducing a carbon-source gas and a silicon-source gas to the process chamber, and
wherein the second step comprises stopping the introduction of the carbon-source gas and the silicon-source gas and then doping the top surface of the silicon carbide film by introducing a source of the predetermined ions to the process chamber, and
wherein the third step comprises stopping the introduction of the source of the predetermined ions and then growing the other silicon carbide film by again introducing the silicon-source gas and the carbon-source gas.

2. The method of forming a buffer layer (200) on a silicon carbide substrate (100) of claim 1, wherein the predetermined ions are n-type dopant ions or p-type dopant ions.

3. The method of forming a buffer layer (200) on a silicon carbide substrate (100) of claim 2, wherein the n-type dopant ions are nitrogen ions or phosphorus ions and the p-type dopant ions are aluminum ions or boron ions.

4. The method of forming a buffer layer (200) on a silicon carbide substrate (100) of claim 1, wherein the silicon carbide film (210) has a thickness of from 10 nm to 200 nm.

5. The method of forming a buffer layer (200) on a silicon carbide substrate (100) of claim 1, wherein the buffer layer has a thickness of from 200 nm to 1000 nm.

6. The method of forming a buffer layer (200) on a silicon carbide substrate (100) of claim 1, wherein the second and third steps are repeated at least twice or more times to form a plurality of layers of silicon carbide films (210).

7. A method of forming a silicon carbide epitaxial wafer, comprising:
providing a silicon carbide substrate (100);
successively forming at least two layers of silicon carbide films (210) on the silicon carbide substrate (100) using the method as defined in any one of claims 1 to 6, which make up a buffer layer (200); and
forming an epitaxial layer (300) on the buffer layer (200).

8. A buffer layer (200) on a silicon carbide substrate (100) formed using the method as defined in any one of claims 1 to 6, wherein the buffer layer (200) comprises at least two layers of silicon carbide films (210) formed on the silicon carbide substrate (100), in adjacent layers of silicon carbide films (210), at least a top doped region (210a) of a lower one of the silicon carbide film close to a top surface of the silicon carbide film is doped with predetermined ions, so as to increase concentration of the predetermined ions in the top doped region (210a), the top doped region (210a) has a thickness of less than 10 nm, and the thickness of the top doped region (210a) is less than a thickness of the remaining portion of the same silicon carbide film under the top doped region (210a).

9. A silicon carbide epitaxial wafer comprising:
a silicon carbide substrate (100);
the buffer layer (200) as defined in claim 8 on the silicon carbide substrate (100); and
an epitaxial layer (300) formed on the buffer layer (200).

## Patentansprüche

1. Verfahren zum Bilden einer Pufferschicht (200) auf einem Siliziumkarbidsubstrat (100), umfassend:
in einem ersten Schritt, Bilden eines Siliziumkarbidfilms (210) auf einer Fläche des Siliziumkarbidsubstrats (100);
in einem zweiten Schritt, Behandeln der Fläche des Siliziumkarbidfilms (210) mit vorbestimmten Ionen, so dass ein oberer dotierter Bereich (210a) des Siliziumkarbidfilms (210) in der Nähe einer oberen Fläche des Siliziumkarbidfilms mit den vorbestimmten Ionen dotiert wird, um eine Konzentration der vorbestimmten Ionen in dem oberen dotierten Bereich (210a) zu erhöhen, wobei der obere dotierte Bereich (210a) eine Dicke von weniger als 10 nm aufweist und die Dicke des oberen dotierten Bereichs (210a) kleiner als eine Dicke des verbleibenden Abschnitts desselben Siliziumkarbidfilms (210) unter dem oberen dotierten Bereich (210a) ist;
in einem dritten Schritt, Bilden einer anderen Schicht aus Siliziumkarbidfilm auf dem Siliziumkarbidfilm (210); und
Wiederholen des zweiten und dritten Schritts mindestens einmal, um nacheinander mindestens zwei Schichten von Siliziumkarbidfilmen (210) zu bilden, die die Pufferschicht (200) ausmachen,
wobei das Siliziumkarbidsubstrat (100) nacheinander den ersten bis dritten Schritten innerhalb derselben Prozesskammer unterzogen wird, wobei der erste Schritt das Bilden des Siliziumkarbidfilms (210) durch Einleiten eines Kohlenstoffquelle-Gases eines Siliziumquelle-Gases in die Prozesskammer umfasst, und
wobei der zweite Schritt ein Beenden der Einführung des Kohlenstoffquelle-Gases und des Siliziumquelle-Gases und dann das Dotieren der oberen Fläche des Siliziumkarbidfilms durch Einführen einer Quelle der vorbestimmten Ionen in die Prozesskammer umfasst, und
wobei der dritte Schritt ein Beenden der Einführung der Quelle der vorbestimmten Ionen und dann ein Wachsen des anderen Siliziumkarbidfilms durch Wiedereinleiten des Siliziumquelle-Gases und des Kohlenstoffquelle-Gases umfasst.

2. Verfahren zum Bilden einer Pufferschicht (200) auf einem Siliziumkarbidsubstrat (100) nach Anspruch 1, wobei die vorbestimmten Ionen n-Dotierungsionen oder p-Dotierungsionen sind.

3. Verfahren zum Bilden einer Pufferschicht (200) auf einem Siliziumkarbidsubstrat (100) nach Anspruch 2, wobei die n-Dotierungsionen Stickstoffionen oder Phosphorionen sind und die p-Dotierungsionen Aluminiumionen oder Borionen sind.

4. Verfahren zum Bilden einer Pufferschicht (200) auf einem Siliziumkarbidsubstrat (100) nach Anspruch 1, wobei der Siliziumkarbidfilm (210) eine Dicke von 10 nm bis 200 nm aufweist.

5. Verfahren zum Bilden einer Pufferschicht (200) auf einem Siliziumkarbidsubstrat (100) nach Anspruch 1, wobei die Pufferschicht eine Dicke von 200 nm bis 1000 nm aufweist.

6. Verfahren zum Bilden einer Pufferschicht (200) auf einem Siliziumkarbidsubstrat (100) nach Anspruch 1, wobei der zweite und der dritte Schritt mindestens zweimal oder öfter wiederholt werden, um mehrere Schichten von Siliziumkarbidfilmen (210) zu bilden.

7. Verfahren zur Herstellung eines Siliziumkarbid-Epitaxialwafers, umfassend:
Bereitstellen eines Siliziumkarbidsubstrats (100);
aufeinanderfolgendes Bilden von mindestens zwei Schichten aus Siliziumkarbidfilmen (210) auf dem Siliziumkarbidsubstrat (100) unter Verwendung des in einem der Ansprüche 1 bis 6 definierten Verfahrens, die eine Pufferschicht (200) bilden; und
Bilden einer Epitaxialschicht (300) auf der Pufferschicht (200).

8. Pufferschicht (200) auf einem Siliziumkarbidsubstrat (100), die unter Verwendung des in einem der Ansprüche 1 bis 6 definierten Verfahrens gebildet wird, wobei die Pufferschicht (200) mindestens zwei Schichten von Siliziumkarbidfilmen (210) umfasst, die auf dem Siliziumkarbidsubstrat (100) gebildet werden, wobei in benachbarten Schichten von Siliziumkarbidfilmen (210) mindestens ein oberer dotierter Bereich (210a) eines unteren der Siliziumkarbidfilme nahe einer oberen Fläche des Siliziumkarbidfilms mit vorbestimmten Ionen dotiert ist, um die Konzentration der vorbestimmten Ionen in dem oberen dotierten Bereich (210a) zu erhöhen, wobei der obere dotierte Bereich (210a) eine Dicke von weniger als 10 nm aufweist und die Dicke des oberen dotierten Bereichs (210a) kleiner als eine Dicke des verbleibenden Abschnitts desselben Siliziumkarbidfilms unter dem oberen dotierten Bereich (210a) ist.

9. Siliziumkarbid-Epitaxialwafer, umfassend:
ein Siliziumkarbidsubstrat (100);
die in Anspruch 8 definierte Pufferschicht (200) auf dem Siliziumkarbidsubstrat (100); und
eine Epitaxialschicht (300), die auf der Pufferschicht (200) gebildet ist.

## Revendications

1. Procédé de formation d'une couche tampon (200) sur un substrat en carbure de silicium (100), comprenant :
dans une première étape, la formation d'un film de carbure de silicium (210) sur une surface du substrat en carbure de silicium (100) ;
dans une deuxième étape, le traitement de la surface du film de carbure de silicium (210) avec des ions prédéterminés de sorte qu'une région dopée supérieure (210a) du film de carbure de silicium (210) près d'une surface supérieure du film de carbure de silicium est dopée avec les ions prédéterminés, de façon à augmenter la concentration des ions prédéterminés dans la région dopée supérieure (210a), la région dopée supérieure (210a) a une épaisseur inférieure à 10 nm, et l'épaisseur de la région dopée supérieure (210a) est inférieure à une épaisseur de la partie restante du même film de carbure de silicium (210) sous la région dopée supérieure (210a) ;
dans une troisième étape, la formation d'une autre couche de film de carbure de silicium sur le film de carbure de silicium (210) ; et
la répétition des deuxième et troisième étapes au moins une fois pour former successivement au moins deux couches de films de carbure de silicium (210) qui constituent la couche tampon (200),
dans lequel le substrat en carbure de silicium (100) est successivement soumis aux première à troisième étapes au sein de la même chambre de traitement, dans lequel la première étape comprend la formation du film de carbure de silicium (210) en introduisant un gaz source de carbone et un gaz source de silicium dans la chambre de traitement, et
dans lequel la deuxième étape comprend l'arrêt de l'introduction du gaz source de carbone et du gaz source de silicium puis le dopage de la surface supérieure du film de carbure de silicium en introduisant une source des ions prédéterminés dans la chambre de traitement, et
dans lequel la troisième étape comprend l'arrêt de l'introduction de la source des ions prédéterminés puis la croissance de l'autre film de carbure de silicium en introduisant de nouveau le gaz source de silicium et le gaz source de carbone.

2. Procédé de formation d'une couche tampon (200) sur un substrat en carbure de silicium (100) selon la revendication 1, dans lequel les ions prédéterminés sont des ions dopants de type n ou des ions dopants de type p.

3. Procédé de formation d'une couche tampon (200) sur un substrat en carbure de silicium (100) selon la revendication 2, dans lequel les ions dopants de type n sont des ions d'azote ou des ions de phosphore et les ions dopants de type p sont des ions d'aluminium ou des ions de bore.

4. Procédé de formation d'une couche tampon (200) sur un substrat en carbure de silicium (100) selon la revendication 1, dans lequel le film de carbure de silicium (210) a une épaisseur allant de 10 nm à 200 nm.

5. Procédé de formation d'une couche tampon (200) sur un substrat en carbure de silicium (100) selon la revendication 1, dans lequel la couche tampon a une épaisseur allant de 200 nm à 1000 nm.

6. Procédé de formation d'une couche tampon (200) sur un substrat en carbure de silicium (100) selon la revendication 1, dans lequel les deuxième et troisième étapes sont répétées au moins deux fois ou plus de deux fois pour former une pluralité de couches de films de carbure de silicium (210).

7. Procédé de formation d'une plaquette épitaxiale en carbure de silicium, comprenant :
la fourniture d'un substrat en carbure de silicium (100) ;
la formation successive d'au moins deux couches de films de carbure de silicium (210) sur le substrat en carbure de silicium (100) à l'aide du procédé selon l'une quelconque des revendications 1 à 6, lesquelles constituent une couche tampon (200) ; et
la formation d'une couche épitaxiale (300) sur la couche tampon (200).

8. Couche tampon (200) sur un substrat en carbure de silicium (100) formée à l'aide du procédé selon l'une quelconque des revendications 1 à 6, dans laquelle la couche tampon (200) comprend au moins deux couches de films de carbure de silicium (210) formées sur le substrat en carbure de silicium (100), dans des couches adjacentes de films de carbure de silicium (210), au moins une région dopée supérieure (210a) d'un inférieur parmi les films de carbure de silicium près d'une surface supérieure du film de carbure de silicium est dopée avec des ions prédéterminés, de façon à augmenter la concentration des ions prédéterminés dans la région dopée supérieure (210a), la région dopée supérieure (210a) a une épaisseur inférieure à 10 nm, et l'épaisseur de la région dopée supérieure (210a) est inférieure à une épaisseur de la partie restante du même film de carbure de silicium sous la région dopée supérieure (210a).

9. Plaquette épitaxiale en carbure de silicium comprenant :
un substrat en carbure de silicium (100) ;
la couche tampon (200) selon la revendication 8 sur le substrat en carbure de silicium (100) ;
et
une couche épitaxiale (300) formée sur la couche tampon (200).
